# EUROPEAN PATENT APPLICATION

(11) **EP 3 930 005 A1**
(43) Date of publication of application: **29.12.2021**
(21) Application number: 20213612.3
(22) Date of filing: 11.12.2020
(51) Int. Cl.: H01L 29/778, H01L 21/338, H01L 29/201, H01L 29/205, H01L 29/417, H01L 29/423, H01L 29/06, H01L 29/20

(54) **TRANSITION METAL-III-NITRIDE ALLOYS FOR ROBUST HIGH PERFORMANCE HEMTS**

(30) Priority: 23.06.2020 US 202016910008
(71) Applicant: INTEL Corporation, Santa Clara, CA 95054 (US)
(72) Inventor: MURTHY, Anand S., Portland, OR Oregon 97229 (US); KOTLYAR, Roza, Portland, OR Oregon 97219 (US); GLASS, Glenn A., Portland, OR Oregon 97229 (US); THEN, Han Wui, Portland, OR Oregon 97229 (US); CHARUE-BAKKER, Sandrine, Portland, OR Oregon 97229 (US); EHLERT, Robert, Portland, OR Oregon 97229 (US); VISHWANATH, Suresh, Portland, OR Oregon 97229 (US)
(74) Representative: 2SPL Patentanwälte PartG mbB

(57) **Abstract**

A high electron mobility transistor (HEMT) is disclosed. The HEMT comprises a heterojunction channel that includes a first semiconductor layer (102) and a second semiconductor layer (106) over the first semiconductor layer. A first interface layer (103) is between the first semiconductor layer and the second semiconductor layer, and a second interface layer (105) is over the first interface layer. The HEMT further comprises a source contact (112), a drain contact (112), and a gate contact (114) between the source contact and the drain contact.

## Description

### TECHNICAL FIELD

Embodiments of the present disclosure relate to semiconductor devices, and more particularly to high electron mobility transistors (HEMTs) with improved performance provided by transition metal-III-nitride alloy layers.

### BACKGROUND

High electron mobility transistors are transistors that include a heterojunction between two semiconductor materials with different bandgaps. HEMTs typically have high gains. As such, HEMTs are useful in amplifier circuitry blocks. HEMTs also exhibit high switching speeds. This is because the main charge carriers in HEMTs are majority carriers, and minority carriers are not significantly involved. HEMTs also exhibit low noise values because the current variation in such devices is low compared to other field effect transistor architectures.

In a HEMT, the semiconductor layer with the wider bandgap (i.e., the first semiconductor layer) is doped with donor atoms to provide excess electrons in the conduction band of the first semiconductor layer. These electrons diffuse to the conduction band of the adjacent semiconductor material with the narrower bandgap (i.e., the second semiconductor layer) due to the availability of states with lower energy. The movement of electrons will cause a change in potential and thus an electric field between the first semiconductor layer and the second semiconductor layer. The electric field will push electrons back to the conduction band of the first semiconductor layer. The diffusion process continues until electron diffusion and electron drift balance each other. This provides a junction at equilibrium similar to a p-n junction, with the second semiconductor layer now having an excess of majority charge carriers. The diffusion of carriers leads to the accumulation of electrons along the boundary of the two regions inside the second semiconductor layer. The accumulation of electrons leads to a very high current in these devices. The accumulated electrons may sometimes be referred to as a two-dimensional electron gas (2DEG). The fact that the charge carriers are majority carriers produces the high switching speeds, and the fact that the second semiconductor layer is undoped means that there are no donor atoms to cause scattering and thus yields high mobility.

### BRIEF DESCRIPTION OF THE DRAWINGS

Figure 1 is a cross-sectional illustration of a HEMT with a first interface layer and a second interface layer in the access regions between the first semiconductor layer and the second semiconductor layer, in accordance with an embodiment.
Figure 2 is a cross-sectional illustration of a HEMT with a first interface layer and a second interface layer between the first semiconductor layer and the second semiconductor layer, in accordance with an embodiment.
Figure 3A is a cross-sectional illustration of a HEMT with a back barrier layer between the first semiconductor layer and a substrate, in accordance with an embodiment.
Figure 3B is a graph depicting the bandgap and lattice parameters of several material systems, in accordance with an embodiment.
Figure 4A is a cross-sectional illustration of a HEMT with a first interface layer, a second interface layer, and a back barrier layer, in accordance with an embodiment.
Figure 4B is a cross-sectional illustration of a HEMT with a first interface layer, a second interface layer, and a back barrier layer, in accordance with an additional embodiment.
Figures 5A-5C are cross-sectional illustrations of a process for forming a HEMT with a replacement gate process, in accordance with an embodiment.
Figures 6A-6C are cross-sectional illustrations of a process for forming a HEMT with an etching process to form a gate opening, in accordance with an embodiment.
Figures 7A-7C are cross-sectional illustrations of a process for forming a HEMT using a second interface layer as an etchstop layer, in accordance with an embodiment.
Figures 8A and 8B are cross-sectional illustrations across the gate contact, in accordance with an embodiment.
Figure 9 illustrates a computing device in accordance with one implementation of an embodiment of the disclosure.
Figure 10 is an interposer implementing one or more embodiments of the disclosure.

### EMBODIMENTS OF THE PRESENT DISCLOSURE

Described herein are high electron mobility transistors (HEMTs) with improved performance provided by transition metal-III-nitride alloy layers, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, HEMTs provide high speed switching, high gains, and lower noise compared to other FET architectures. However, HEMTs may suffer from other drawbacks. One such drawback is a relatively high contact resistance. Another drawback is threshold voltage variation between devices (within die and/or within wafer). The variation is attributable to a low etch selectivity between an interface layer and the top semiconductor layer. For example, in a GaN/AlGaN system with a AlN interface layer, there is poor etch selectivity between the AlGaN and the AlN layers. This results in under-etching and/or over-etching of the gate recess. Without a uniform thickness between the gate contact and the GaN layer, the voltage threshold is non-uniform. An additional issue arises in architectures with a back barrier layer between the bottom semiconductor layer and the buffer layer. In such architectures, a back barrier layer with a sufficient bandgap difference relative to the bottom semiconductor layer will have a significant lattice mismatch. As such, the bottom semiconductor layer may include lattice defects.

Accordingly, embodiments disclosed herein include a second interface layer formed with a transition metal-III-nitride alloy. The second interface layer may be disposed over the first interface layer between the two semiconductor layers. Such second interface layers provide several benefits. For example, a transition metal-III-nitride alloy provides a greater polarization charge in the HEMT while still remaining physically distant from the 2DEG. The greater polarization charge in the access region lowers the contact resistance. Furthermore, due to the physical separation from the 2DEG, there is no increase in alloy scattering of electrons.

A transition metal-III-nitride alloy used as a second interface layer may also provide etch selectivity that allows for improved threshold voltage uniformity. Particularly, a transition metal-III-nitride alloy, such as ScAIN, may have an etch selectivity to AlN and GaN. The second interface layer may, therefore, be utilized as an etchstop layer in order to provide a uniform gate recess, which provides a high threshold voltage uniformity.

Additionally, embodiments may utilize similar transition metal-III-nitride alloys as a back barrier layer. The alloying percentages of the transition metal-III-nitride back barrier layer may be modified to provide a lattice parameter that substantially matches a lattice parameter of the bottom semiconductor layer. In addition to matching the lattice parameter, the transition metal-III-nitride alloy has a wider bandgap and a larger conduction band offset to GaN compared to traditional back barrier layer materials. This enables better electron confinement and a smaller leakage through the substrate.

In a particular embodiment, the transition metal-III-nitride alloy comprises Sc_{X}Al_{1-X}N, which is referred to as ScAIN for short. As used herein, references to ScAIN may also be considered to refer to any transition metal-III-nitride alloy, unless stated otherwise. ScAIN layers provide significant advantages in HEMT architectures as described above. However, it has proven difficult to form ScAIN layers at high volume manufacturing (HVM) scale. This is because ScAIN is typically deposited with molecular beam epitaxy (MBE), which has throughput limitations. However, embodiments disclosed herein allow for HVM processing of HEMTs using a metal-organic chemical vapor deposition (MOCVD) process, which allows for a significantly higher throughput.

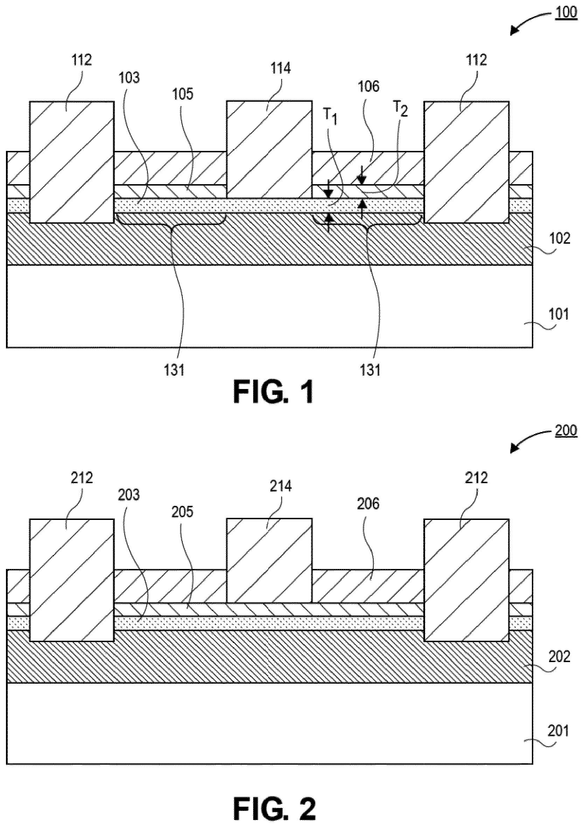

Referring now to Figure 1, a cross-sectional illustration of a HEMT 100 is shown, in accordance with an embodiment. In an embodiment, the HEMT 100 may be disposed over a substrate 101. The substrate 101 may comprise an underlying semiconductor substrate and a buffer layer. The buffer layer may provide a plurality of layers with varying alloy percentages in order to translate a lattice parameter of the underlying substrate to a lattice parameter of an overlying first semiconductor layer 102.

In an embodiment, the underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials.

In an embodiment, the HEMT 100 may comprise a first semiconductor layer 102 and a second semiconductor layer 106 to form a heterojunction. The first semiconductor layer 102 and the second semiconductor layer 106 may sometimes be referred to as a channel of the HEMT 100. In an embodiment, the first semiconductor layer 102 has a first bandgap and the second semiconductor layer 106 has a second bandgap. As such, a heterojunction is provided in the HEMT 100. In a particular embodiment, the first semiconductor layer 102 comprises GaN and the second semiconductor layer 106 comprises AlGaN. However, it is to be appreciated that other material systems may be used to form the heterojunction of the HEMT 100. For example, the first semiconductor layer 102 and the second semiconductor layer 106 may comprise nitrides of Al, Ga and In, or alloys of Al, Ga and In.

In an embodiment, the HEMT 100 may further comprise a first interface layer 103 and a second interface layer 105 between the first semiconductor layer 102 and the second semiconductor layer 106. The first interface layer 103 may comprise AlN, and the second interface layer 105 may comprise a transition metal-III-nitride alloy, such as ScAlN. In an embodiment, the first interface layer 103 may have a first thickness T₁ and the second interface layer 105 may have a second thickness T₂. The thicknesses T₁ and T₂ are minimal, in order to not disrupt the heterojunction. For example, the first thickness T₁ and the second thickness T₂ may each be less than approximately 3nm, or approximately 1nm or less. In an embodiment, the first thickness T₁ and the second thickness T₂ are approximately the same. In other embodiments, the first thickness T₁ is different than the second thickness T₂.

In an embodiment, the first interface layer 103 is a blanket layer over the first semiconductor layer 102. The second interface layer 105 is over the first interface layer 103, except for in the gate recess. That is, the gate contact 114 may pass through the second interface layer 105 in some embodiments. In the access regions 131 on either side of the gate contact 114, the second interface layer 105 is stacked directly over the first interface layer 103. The presence of the second interface layer 105 is readily detected using various analysis techniques. For example, the presence of the transition metal of the alloy of the second interface layer 105 is detectable using techniques, such as, but not limited to, SIMS, x-SEM EDX, TEM EDX, or EELS.

The inclusion of the second interface layer 105 in the access region decreases the contact resistance of the HEMT 100. This is because the second interface layer 105 provides a higher interfacial polarization charge compared to the overlying second semiconductor layer 106. For example, the interfacial polarization charge supplied by ScAIN is greater than the interfacial polarization charge supplied by AlGaN when grown epitaxially over GaN. The higher interfacial polarization charge provides a higher charge in the access region. Additionally, the first interface layer 103 provides a physical separation between the second interface layer 105 and the first semiconductor layer 102. As such, alloy scattering due to the second interface layer 105 is limited.

In an embodiment, the HEMT 100 may further comprise a pair of source/drain (S/D) contacts 112. The S/D contacts 112 may be on opposite sides of the gate contact 114. The S/D contacts 112 are spaced away from the gate contact 114 by the access regions 131. In an embodiment, the S/D contacts 112 pass through the second semiconductor layer 106, the second interface layer 105, and the first interface layer 103. In some embodiments, the S/D contacts 112 may also extend into the first semiconductor layer 102. In an embodiment, the S/D contacts 112 may be etch undercut followed by regrowth or implanted followed by metal contact.

Referring now to Figure 2, a cross-sectional illustration of a HEMT 200 is shown, in accordance with an additional embodiment. The HEMT 200 may be substantially similar to the HEMT 100 with the exception that the gate contact 214 does not pass through the second interface layer 205. For example, the HEMT 200 may comprise a substrate 201, a first semiconductor layer 202, a first interface layer 203, a second interface layer 205, and a second semiconductor layer 206. In an embodiment, the HEMT 200 further comprises S/D contacts 212.

As shown, the second interface layer 205 is a blanket layer over the first interface layer 203. For example, between the S/D contacts 212, the top surface of the first interface layer 203 is covered by the second interface layer 205. Such an embodiment results in a more uniform threshold voltage between devices (e.g., between devices within a single die, between devices within a single wafer, and/or between devices across different wafers). This is because the second interface layer 205 also functions as an etchstop layer for the gate contact recess.

Typically, the material systems used for the second semiconductor layer 206 and the first interface layer 203 do not have a high etch selectivity. That is, an etchant used to etch the second semiconductor layer 206 also readily etches the first interface layer 203. For example, when the second semiconductor layer 206 comprises AlGaN and the first interface layer 203 comprises AlN, an etchant to remove the second semiconductor layer 206 will also etch the first interface layer 203. This leads to instances of the gate recess (e.g., within a die, within the wafer, and/or between devices across different wafers) to be either over-etched or under-etched.

However, when the second interface layer 205 has an etch selectivity to the second semiconductor layer 206, the gate recess will be uniform (e.g., within a die, within the wafer, and/or between devices across different wafers). This is because an etchant to remove the second semiconductor layer 206 will not substantially etch the second interface layer 205. As such, the distance between a bottom surface of the gate contact 214 and the top surface of the first semiconductor layer 202 will have a high uniformity within a die and within a wafer. This provides a highly uniform voltage threshold. One such material system that exhibits such etch selectivity is an AlGaN second semiconductor layer 206 and a ScAIN second interface layer 205. ScAIN, even at low alloying of approximately 2%, has demonstrated sufficient etch resistance to GaN and AlN. Increasing the Sc percentage in the alloy makes the etch resistance even stronger. It is to be appreciated that enabling a more uniform threshold voltage may come at the cost of a larger negative threshold voltage due to enhanced polarization charge in the channel. However, this tradeoff can be optimized by controlling the thickness, composition, and doping of the second interface layer 205.

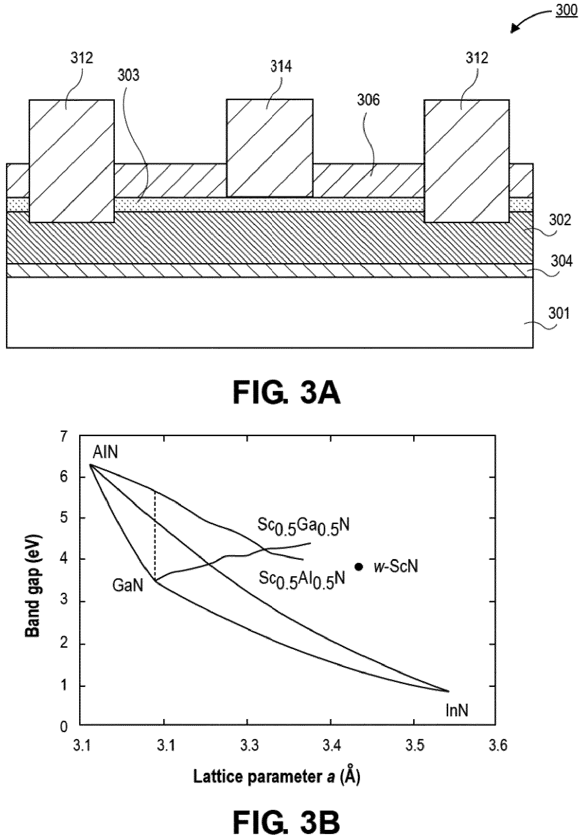

Referring now to Figure 3A, a cross-sectional illustration of a HEMT 300 is shown, in accordance with an embodiment. The HEMT 300 may comprise a substrate 301, a back barrier layer 304, a first semiconductor layer 302, a first interface layer 303, and a second semiconductor layer 306. S/D contacts 312 and a gate contact 314 are also provided in the HEMT 300. In an embodiment, the substrate 301, the first semiconductor layer 302, the first interface layer 303, the second semiconductor layer 306, the S/D contacts 312, and the gate contact 314 may be substantially similar to features similarly numbered features (e.g., 301 is similar to 201 and 101) described with respect to HEMT 100 and HEMT 200.

The back barrier layer 304 is positioned between the substrate 301 and the first semiconductor layer 302. The back barrier layer 304 provides improved electron confinement while lowering dislocations in the first semiconductor layer 302. Ideally, a back barrier layer 304 will provide a wide bandgap in order to confine electrons and limit leakage. However, high bandgap materials typically used in back barrier layers 304 (e.g., AlGaN and BGaN) have a large lattice mismatch with GaN. Accordingly, dislocation defects are present in the subsequently grown first semiconductor layer.

However, in embodiments disclosed herein, the back barrier layer 304 may comprise a transition metal-III-nitride alloy. For example, the back barrier layer 304 may comprise ScAlN. ScAIN provides a material system with a high bandgap that can be lattice matched to GaN. For example, Figure 3B illustrates a graph of lattice parameters relative to the bandgap of a ScxAl_{1-X}N system. As shown, the lattice parameter of GaN is approximately 3.2 Å. Going directly up from GaN (as shown by the dashed line) the ScAIN alloy line is intersected. Therefore, a ScAIN alloy that comprises a bandgap that is larger than GaN while having the same lattice parameter is available for use as a back barrier layer 304.

In Figures 1-3B, the gate contacts 114, 214, and 314 are shown as having a rectangular shape. However, it is to be appreciated that embodiments are not limited to such configurations. For example, a gate contact 114, 214, and/or 314 may have a T-shaped cross-section. That is, a first end of the gate contact 114, 214, and/or 314 away from the heterojunction may have a width that is larger than a width of a second end of the gate contact 114, 214, and/or 314. Additional embodiments may also include an oxide under the gate contact 114, 214, and/or 314. That is, an oxide layer may separate the gate contact 114, 214, and/or 314 from the first interface layer, the second interface layer, or the first semiconductor layer.

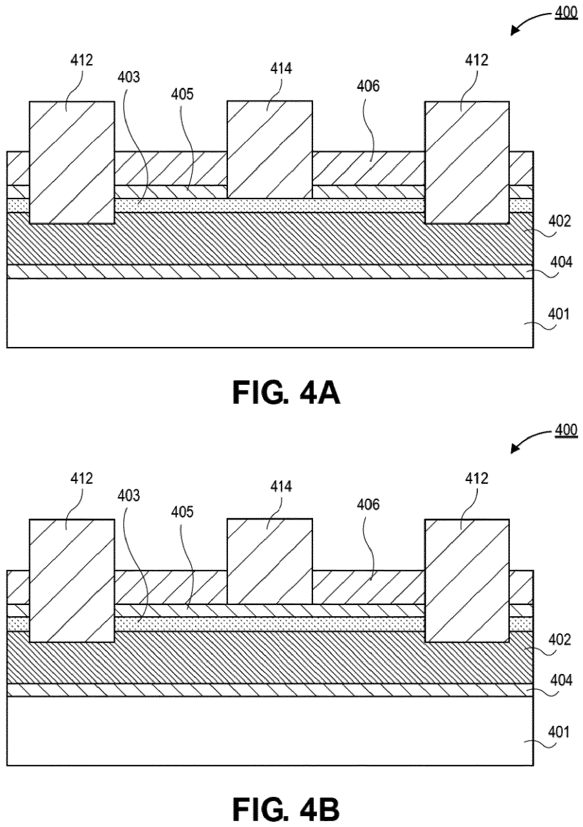

Referring now to Figures 4A and 4B, cross-sectional illustrations of various HEMTs 400 are shown, in accordance with additional embodiments. Figure 4A illustrates a HEMT 400 that is substantially similar to the HEMT 100 with the addition of a back barrier layer 404, in accordance with an embodiment. That is, the HEMT 400 may comprise a substrate 401, a back barrier layer 404 over the substrate 401, a first semiconductor layer 402 over the back barrier layer 404, a first interface layer 403 and a second interface layer 405 over the first semiconductor layer 402, and a second semiconductor layer 406 over the second interface layer 405. The S/D contacts 412 may pass through the second semiconductor layer 406, the second interface layer 405, and the first interface layer 403. The S/D contacts 412 may pass into the first semiconductor layer 402. In an embodiment, the gate contact 414 may pass through the second interface layer 405.

The HEMT 400 in Figure 4A provides the combined advantages of the HEMT 100 and the HEMT 300. Particularly, the second interface layer 405 provides a lower contact resistance, and the back barrier layer 404 provides improved electron confinement and reduced leakage.

Referring now to Figure 4B, a cross-sectional illustration of a HEMT 400 is shown, in accordance with an additional embodiment. The HEMT 400 combines the features of HEMT 200 and HEMT 300. Particularly, the bottom surface of the gate contact 414 is spaced away from the first semiconductor layer 402 by both the first interface layer 403 and the second interface layer 405. That is, the second interface layer 405 functions as an etchstop layer to provide improved threshold voltage uniformity. Additionally, the back barrier layer 404 provides improved electron confinement and reduced leakage.

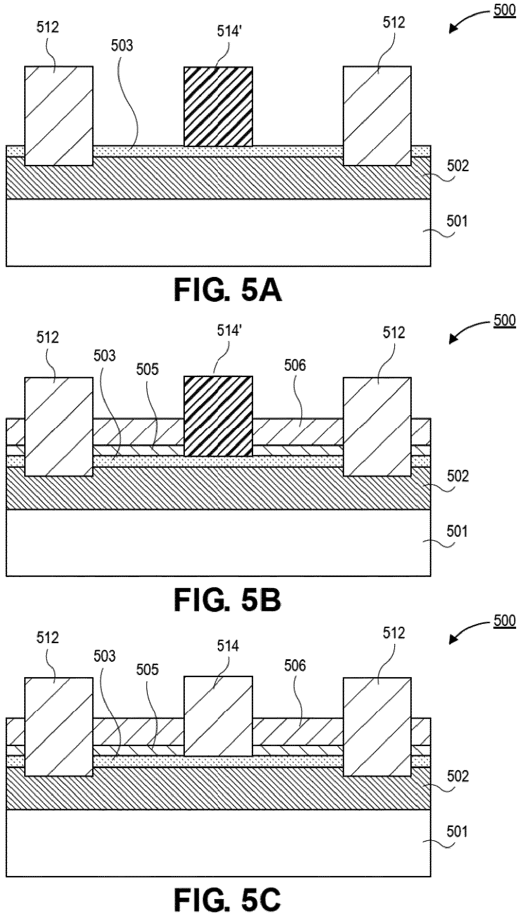

Referring now to Figures 5A-5C, a series of cross-sectional illustrations depicting a process for forming a HEMT 500 is shown, in accordance with an embodiment.

Referring now to Figure 5A, a cross-sectional illustration of a partially manufactured HEMT 500 is shown, in accordance with an embodiment. In an embodiment, the HEMT 500 may comprise a substrate 501 and a first semiconductor layer 502 over the substrate 501. A first interface layer 503 is disposed over the first semiconductor layer 502. S/D contacts 512 may be disposed through the first interface layer 503 and into the first semiconductor layer 502. In an embodiment, a dummy gate contact 514' is disposed over the first interface layer 503 between the S/D contacts 512.

Referring now to Figure 5B, a cross-sectional illustration of the HEMT 500 after the second interface layer 505 and the second semiconductor layer 506 are grown is shown, in accordance with an embodiment. The second interface layer 505 and the second semiconductor layer 506 may be grown with any suitable process. In an embodiment, the second interface layer 505 may be grown with a MOCVD process. The second interface layer 505 may comprise a transition metal-III-nitride alloy, such as, but not limited to ScAlN. In an embodiment, the second semiconductor layer 506 may comprise AlGaN, and the first semiconductor layer 502 may comprise GaN.

Due to the presence of the dummy gate contact 514', the second interface layer 505 and the second semiconductor layer 506 are not disposed over the entire top surface of the first interface layer 503. That is, the gate recess is defined by the dummy gate contact 514'.

Referring now to Figure 5C, a cross-sectional illustration of the HEMT 500 after the gate contact 514 is disposed in the gate recess is shown, in accordance with an embodiment. The dummy gate contact 514' may be removed (e.g., with an etching process) and the gate contact 514 may be deposited in place of the dummy gate contact 514'. Such a process may be referred to as a gate last fabrication process.

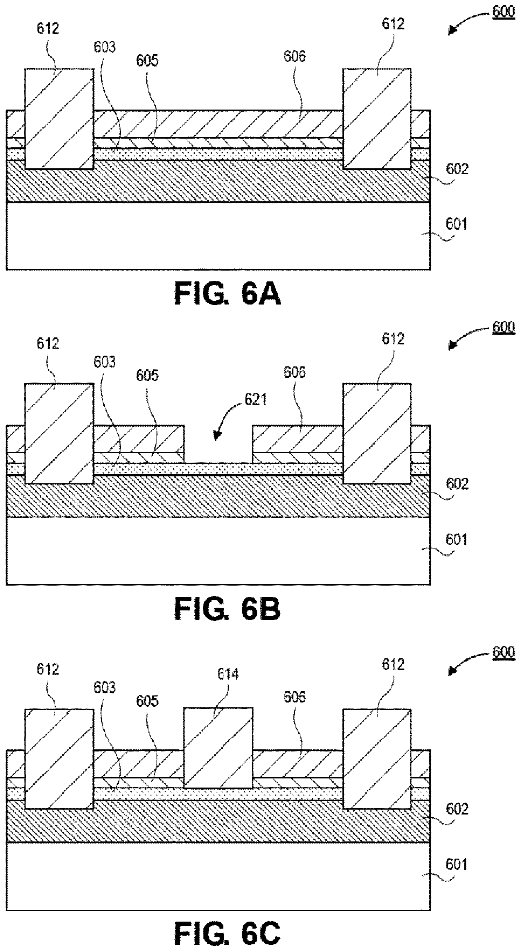

Referring now to Figures 6A-6C, a series of cross-sectional illustrations depicting a process for forming a HEMT 600 is shown, in accordance with an additional embodiment.

Referring now to Figure 6A, a cross-sectional illustration of a partially manufactured HEMT 600 is shown, in accordance with an embodiment. In an embodiment, the HEMT 600 may comprise a substrate 601 and a first semiconductor layer 602 over the substrate 601. A first interface layer 603 is disposed over the first semiconductor layer 602. A second interface layer 605 and a second semiconductor layer 606 may be disposed over the first interface layer 603. In an embodiment, S/D contacts 612 may be disposed through the second semiconductor layer 606, the second interface layer 605, the first interface layer 603 and into the first semiconductor layer 602.

As shown, the second interface layer 605 and the second semiconductor layer 606 cover an entire top surface of the first interface layer 603. In an embodiment, the first semiconductor layer 602 may comprise GaN, the first interface layer 603 may comprise AlN, the second interface layer 605 may comprise a transition metal-III-nitride alloy, such as ScAlN, and the second semiconductor layer 606 may comprise AlGaN. However, it is to be appreciated that other material systems may be used for the HEMT 600.

Referring now to Figure 6B, a cross-sectional illustration of the HEMT 600 after a gate recess 621 is disposed through the second semiconductor layer 606 and the second interface layer 605 is shown, in accordance with an embodiment. The gate recess 621 may be formed with an etching process. In a particular embodiment, the etching process may comprise a first etching chemistry to etch through the second semiconductor layer 606, and a second etching chemistry to etch through the second interface layer 605. The gate recess 621 exposes a top surface of the first interface layer 603.

Referring now to Figure 6C, a cross-sectional illustration of the HEMT 600 after a gate contact 614 is disposed into the gate recess 621 is shown, in accordance with an embodiment. The gate contact 614 contacts the first interface layer 603 and passes through the second interface layer 605 and through the second semiconductor layer 606.

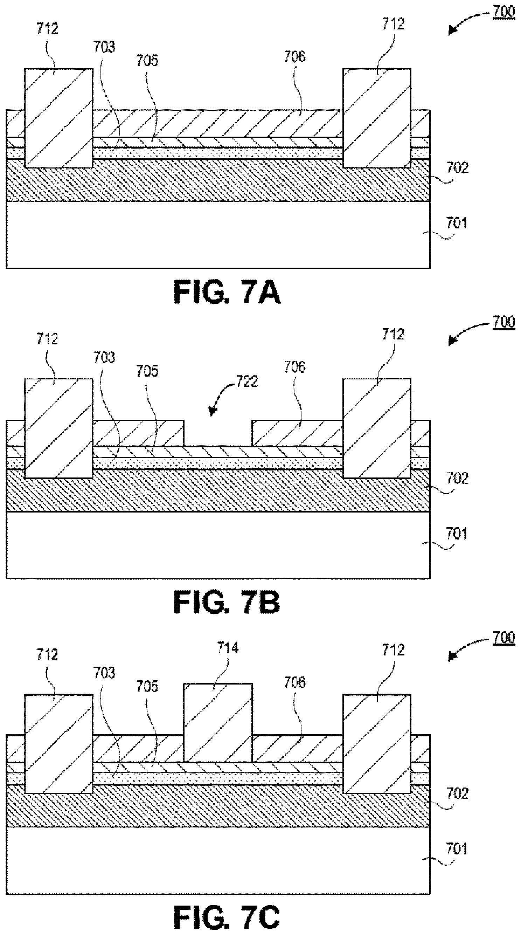

Referring now to Figures 7A-7C, a series of cross-sectional illustrations depict a process for forming a HEMT 700 is shown, in accordance with an embodiment.

Referring now to Figure 7A, a cross-sectional illustration of a partially manufactured HEMT 700 is shown, in accordance with an embodiment. In an embodiment, the HEMT 700 may comprise a substrate 701 and a first semiconductor layer 702 over the substrate 701. A first interface layer 703 is disposed over the first semiconductor layer 702. A second interface layer 705 and a second semiconductor layer 706 may be disposed over the first interface layer 703. In an embodiment, S/D contacts 712 may be disposed through the second semiconductor layer 706, the second interface layer 705, the first interface layer 703 and into the first semiconductor layer 702.

As shown, the second interface layer 705 and the second semiconductor layer 706 cover an entire top surface of the first interface layer 703. In an embodiment, the first semiconductor layer 702 may comprise GaN, the first interface layer 703 may comprise AlN, the second interface layer 705 may comprise a transition metal-III-nitride alloy, such as ScAlN, and the second semiconductor layer 706 may comprise AlGaN. However, it is to be appreciated that other material systems may be used for the HEMT 700.

Referring now to Figure 7B, a cross-sectional illustration of the HEMT 700 after a gate recess 722 is disposed through the second semiconductor layer 706 is shown, in accordance with an embodiment. The gate recess 722 may be formed with an etching process. Particularly, the etching process may include an etching chemistry that is selective to the second semiconductor layer 706 over the second interface layer 705. The second interface layer 705, therefore, may function as an etchstop layer. Accordingly, the distance between the bottom of the gate recess 722 may have a tightly controlled spacing from the top surface of the first semiconductor layer 702. This allows for a highly uniform threshold voltage between devices on a die, between devices on a wafer, and/or between devices on different wafers.

Referring now to Figure 7C, a cross-sectional illustration of the HEMT 700 after a gate contact 714 is disposed into the gate recess 722 is shown, in accordance with an embodiment. The gate contact 714 contacts the second interface layer 705 and passes through the second semiconductor layer 706.

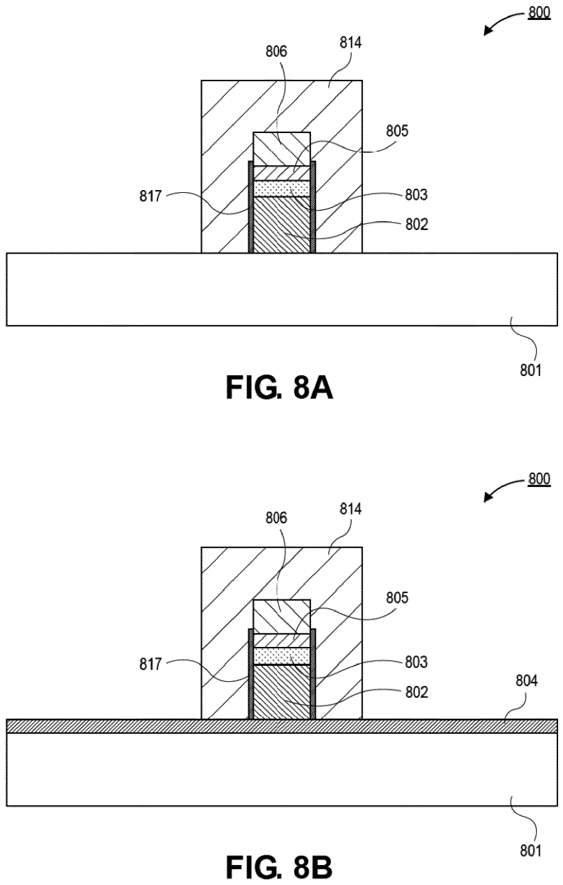

In the embodiments described above, the HEMTs are each shown as having a planar transistor configuration. However, it is to be appreciated that HEMTs in accordance with embodiments disclosed herein are not limited to such configurations. For example, non-planar transistor architectures may also benefit from the use of interface layers. For example, Figures 8A and 8B are cross-sectional illustrations across the gate contact. Particularly, the HEMTs 800 in Figures 8A and 8B include a fin-based architecture.

Referring now to Figure 8A, a cross-sectional illustration of a non-planar HEMT 800 is shown, in accordance with an embodiment. In an embodiment, the HEMT 800 comprises a substrate 801. A fin is disposed over the substrate 801. For example, the fin may comprise a first semiconductor layer 802, a first interface layer 803, a second interface layer 805, and a second semiconductor layer 806. In a particular embodiment, the first semiconductor layer 802 comprises GaN, the first interface layer 803 comprises AlN, the second interface layer 805 comprises ScAlN, and the second semiconductor layer comprises AlGaN. However, it is to be appreciated that the fin may comprise any suitable stack of layers, such as those described herein. Particularly, the second interface layer 805 may comprise a transition metal-III-nitride material.

As shown, the gate contact 814 wraps around more than one surface of the fin. That is, the gate contact 814 may wrap along sidewalls and a top surface of the fin to form a tri-gate devices (which may also sometimes be referred to as a "fin-FET" device). In an embodiment, the gate contact 814 is in direct contact with the second semiconductor layer 806. Other portions of the fin may be separated from the gate contact 814 by a dielectric layer 817. For example, the dielectric layer 817 may comprise an oxide or a nitride. In an embodiment, the dielectric layer 817 separates each of the first semiconductor layer 802, the first interface layer 803, and the second interface layer 805 from the gate contact 814.

Referring now to Figure 8B, a cross-sectional illustration of a HEMT 800 is shown, in accordance with an additional embodiment. The HEMT 800 in Figure 8B may be substantially similar to the HEMT 800 in Figure 8A, with the exception of the inclusion of a back barrier layer 804. As shown, the back barrier layer 804 separates the bottom of the fin (i.e., the first semiconductor layer 802) from the substrate 801. The back barrier layer 804 may comprise a transition metal-III-nitride, such as, but not limited to, ScAlN.

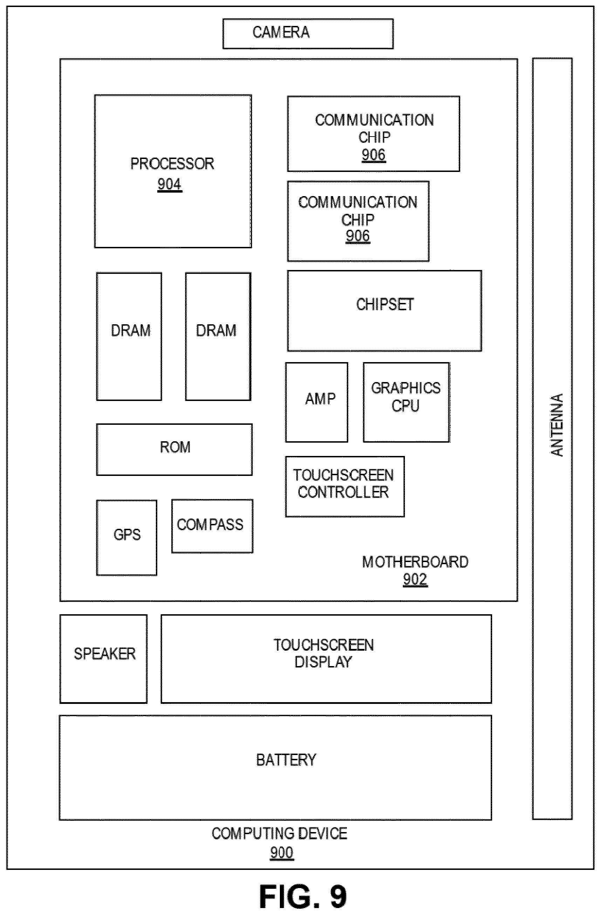

Figure 9 illustrates a computing device 900 in accordance with one implementation of an embodiment of the disclosure. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In an embodiment, the integrated circuit die of the processor may comprise a HEMT with an interface layer comprising a transition metal-III-nitride, such as those described herein. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In an embodiment, the integrated circuit die of the communication chip may comprise a HEMT with an interface layer comprising a transition metal-III-nitride, such as those described herein.

In further implementations, another component housed within the computing device 900 may comprise a HEMT with an interface layer comprising a transition metal-III-nitride, such as those described herein.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

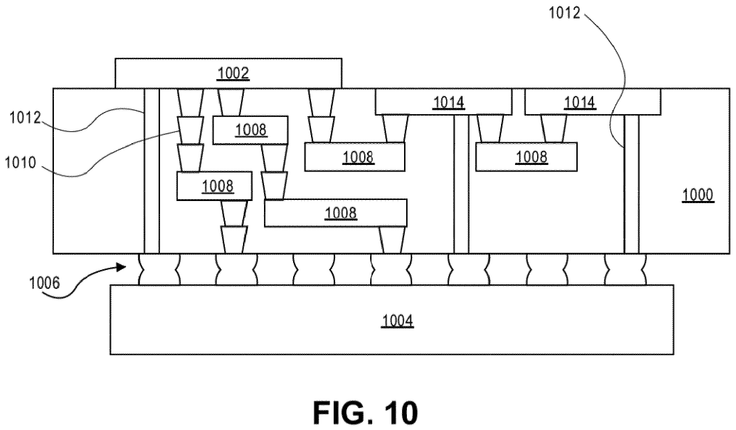

Figure 10 illustrates an interposer 1000 that includes one or more embodiments of the disclosure. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. In an embodiment, one of both of the first substrate 1002 and the second substrate 1004 may comprise a HEMT with an interface layer comprising a transition metal-III-nitride, in accordance with embodiments described herein. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials

The interposer 1000 may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the disclosure, apparatuses or processes disclosed herein may be used in the fabrication of interposer 1000.

Thus, embodiments of the present disclosure may comprise a HEMT with an interface layer comprising a transition metal-III-nitride, and the resulting structures.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.
Example 1: a high electron mobility transistor (HEMT), comprising: a heterojunction channel comprising: a first semiconductor layer; a second semiconductor layer over the first semiconductor layer; a first interface layer between the first semiconductor layer and the second semiconductor layer; and a second interface layer over the first interface layer; a source contact; a drain contact; and a gate contact between the source contact and the drain contact.
Example 2: the HEMT of Example 1, wherein the second interface layer comprises an alloy comprising a transition metal, a group III element, and nitrogen.
Example 3: the HEMT of Example 2, wherein the second interface layer comprises scandium, aluminum, and nitrogen.
Example 4: the HEMT of Examples 1-3, wherein the first semiconductor layer comprises gallium and nitrogen, and wherein the second semiconductor layer comprises aluminum, gallium, and nitrogen.
Example 5: the HEMT of Examples 1-4, wherein the first interface layer comprises aluminum and nitrogen.
Example 6: the HEMT of Examples 1-5, wherein a first thickness of the first interface layer is less than approximately 2nm and wherein a second thickness of the second interface layer is less than approximately 2nm.
Example 7: the HEMT of Examples 1-6, wherein the gate contact passes through the second semiconductor layer.
Example 8: the HEMT of Example 7, wherein the gate contact passes through the second interface layer.
Example 9: the HEMT of Examples 1-8, further comprising: a back barrier layer between the first semiconductor layer and a buffer layer.
Example 10: the HEMT of Example 9, wherein the back barrier layer is an alloy comprising a transition metal, a group III element, and nitrogen.
Example 11: the HEMT of Example 10, wherein the back barrier layer comprises scandium, aluminum, and nitrogen.
Example 12: the HEMT of Example 10, wherein a first lattice parameter of the back barrier layer matches a second lattice parameter of the first semiconductor layer.
Example 13: the HEMT of Example 10, wherein the back barrier layer comprises the same alloy constituents as the second interface layer.
Example 14: a semiconductor device, comprising: a first semiconductor layer comprising gallium and nitrogen; a first interface layer over the first semiconductor layer, wherein the first interface layer comprises aluminum and nitrogen; a second interface layer over the first interface layer, wherein the second interface layer is an alloy comprising a transition metal, a group III element, and nitrogen; and a second semiconductor layer over the second interface layer, wherein the second semiconductor layer comprises aluminum, gallium, and nitrogen.
Example 15: the semiconductor device of Example 14, wherein a thickness of the second interface layer is less than approximately 2nm.
Example 16: the semiconductor device of Example 14 or Example 15, wherein the second interface layer is an alloy comprising, scandium, aluminum, and nitrogen.
Example 17: the semiconductor device of Examples 14-15, further comprising: a source contact; a drain contact; and a gate contact.
Example 18: the semiconductor device of Example 17, wherein the gate contact has a T-shape.
Example 19: the semiconductor device of Example 17 or Example 18, wherein the gate contact passes through the second semiconductor layer.
Example 20: the semiconductor device of Example 19, wherein the gate contact passes through the second interface layer.
Example 21: the semiconductor device of Examples 14-20, further comprising: a back barrier layer under the first semiconductor layer.
Example 22: the semiconductor device of Example 21 wherein the back barrier layer is an alloy comprising the same elements as the second interface layer.
Example 23: an electronic device, comprising: a board; an electronic package attached to the board; a die electrically coupled to the electronic package, wherein the die comprises a high electron mobility transistor (HEMT), comprising: a heterojunction channel comprising: a first semiconductor layer; a second semiconductor layer over the first semiconductor layer; a first interface layer between the first semiconductor layer and the second semiconductor layer; and a second interface layer over the first interface layer; a source contact; a drain contact; and a gate contact between the source contact and the drain contact.
Example 24: the electronic device of Example 23, wherein the second interface layer comprises an alloy comprising a transition metal, a group III element, and nitrogen.
Example 25: the electronic device of Example 24, wherein the second interface layer comprises scandium, aluminum, and nitrogen.

## Claims

1. A high electron mobility transistor (HEMT), comprising:
a heterojunction channel comprising:
a first semiconductor layer;
a second semiconductor layer over the first semiconductor layer;
a first interface layer between the first semiconductor layer and the second semiconductor layer; and
a second interface layer over the first interface layer;
a source contact;
a drain contact; and
a gate contact between the source contact and the drain contact.

2. The HEMT of claim 1, wherein the second interface layer comprises an alloy comprising a transition metal, a group III element, and nitrogen.

3. The HEMT of claim 2, wherein the second interface layer comprises scandium, aluminum, and nitrogen.

4. The HEMT of claim 1, 2 or 3, wherein the first semiconductor layer comprises gallium and nitrogen, and wherein the second semiconductor layer comprises aluminum, gallium, and nitrogen.

5. The HEMT of claim 1, 2, 3 or 4, wherein the first interface layer comprises aluminum and nitrogen.

6. The HEMT of claim 1, 2, 3, 4 or 5, wherein a first thickness of the first interface layer is less than approximately 2nm and wherein a second thickness of the second interface layer is less than approximately 2nm.

7. The HEMT of claim 1, 2, 3, 4, 5 or 6, wherein the gate contact passes through the second semiconductor layer.

8. The HEMT of claim 7, wherein the gate contact passes through the second interface layer.

9. The HEMT of claim 1, 2, 3, 4, 5, 6, 7 or 8, further comprising:
a back barrier layer between the first semiconductor layer and a buffer layer.

10. The HEMT of claim 9, wherein the back barrier layer is an alloy comprising a transition metal, a group III element, and nitrogen.

11. The HEMT of claim 10, wherein the back barrier layer comprises scandium, aluminum, and nitrogen.

12. The HEMT of claim 10, wherein a first lattice parameter of the back barrier layer matches a second lattice parameter of the first semiconductor layer.

13. A method of fabricating a high electron mobility transistor (HEMT), the method comprising:
forming a heterojunction channel comprising:
a first semiconductor layer;
a second semiconductor layer over the first semiconductor layer;
a first interface layer between the first semiconductor layer and the second semiconductor layer; and
a second interface layer over the first interface layer;
forming a source contact;
forming a drain contact; and
forming a gate contact between the source contact and the drain contact.

14. The method of claim 13, wherein the second interface layer comprises an alloy comprising a transition metal, a group III element, and nitrogen.

15. The method of claim 14, wherein the second interface layer comprises scandium, aluminum, and nitrogen.
